Europäisches Patentamt

(19) European Patent Office

Office européen des brevets

(11) Publication number : **0 505 227 A2**

(12) **EUROPEAN PATENT APPLICATION**

(21) Application number : 92400549.9

(22) Date of filing : 03.03.92

(51) Int. Cl.⁵ : **H01L 21/84, H01L 21/033, H01L 21/027**

(30) Priority : **20.03.91 JP 81723/91**

(43) Date of publication of application :
**23.09.92 Bulletin 92/39**

(84) Designated Contracting States :
**DE FR GB NL**

(71) Applicant : **GTC CORPORATION**
**1-6-5 Higashi Nihonbashi**
**Chuo-ku, Tokyo (JP)**

(72) Inventor : **Akimoto, Yasumasa**
**c/o GTC CORPORATION, 1-6-5,**
**Higashi-Nihonbashi**
**Chuo-ku, Tokyo (JP)**
Inventor : **Kobayasi, Masayosi**
**c/o GTC CORPORATION, 1-6-5,**
**Higashi-Nihonbashi**
**Chuo-ku, Tokyo (JP)**

(74) Representative : **Fort, Jacques**
**CABINET PLASSERAUD 84, rue d'Amsterdam**
**F-75009 Paris (FR)**

(54) **Method for making resist patterns for large area circuit base.**

(57)   This invention presents a method of producing resist patterns on a large substrate base for use in active matrix type display panels. A feature of the invention is the display matrix circuit section which is located on the same substrate base as the display control circuit section. In the production of such a substrate base by the process of etching photoresist patterns, more than two different types of circuit printing processes are employed, depending on the resolution accuracy required for the circuit patterns for the matrix display circuit section, the display control circuits and the electrode terminal peripheral regions.

EP 0 505 227 A2

## Background of the Invention

This invention relates to large area display panels of active matrix type, such as thin film transistor (TFT) controlled liquid crystal display panels. Specifically, the invention is concerned with a method of forming display circuit section and TFT control circuit section on a common substrate base. The invention is particularly useful for those circuits which involve different degrees of precision for line widths and positional alignment between the matrix circuit section and the control circuit section. Further, the method is applicable particularly to large screens of over 500 mm corner to corner (c/c) dimension.

One of the matrix type display panels in current use is a liquid crystal display panels.

Display matrix technology involves complex display driving circuitries, and many technical problems occur in making the complex connections between the display circuitries and the display control circuitries. Defect problems become severe as the picture elements of the display circuit section become small, and as the number of picture elements increases.

Such problems associated with the circuit connections can be avoided by forming those control circuits which are situated close to the matrix circuits on one substrate base, and R&D efforts into such techniques are continuing in the industry.

In this invention, the method of forming matrix sections and at least one portion of the control circuits on one substrate base is termed site sharing (SS) method. Generally, the layer architecture of the TFTs in the control circuit is the same as that of the element switching in the matrix display circuit section, and they differ only in the size and circuitry. The SS method is being developed for active matrix type liquid crystal display equipment using polysilicon crystals (p-Si). (Transactions of the Society of Electronic Information Transmissions, C-11, vol. J-72-C-11, No. 10, pp 943-951, (1989)).

In the meanwhile, the display area of such information display equipment is tending to increase yearly. For example, in CRT displays, 14 inch screen dimension is regarded to be a small size, and the demand is greater for screens in the range of 20-30 inches or larger. In the case of active matrix type liquid crystal display panels, the screen size has been increasing from 3-5 inches to 7 inches, and in recent years, screens in the range of 14-15 inches have become available in the marketplace. The TFTs for such screens are made by so-called photolithography technique.

The present inventors have disclosed a method for forming resist patterns in US patent application serial number, 671,037 and in the corresponding EPC application number 91 420 089. 4. The objective in the above noted application is to present a high productivity method of forming TFT circuits for element switching matrix type on a large substrate base for producing display screens of c/c dimension of over 40 inches.

The present invention represents a result of further progress of the above method, and the concept of "formation of resist patterns by printing methods" presented in the present invention is the same concept disclosed in the previous inventions (USSN 671,037 and the corresponding EPC application 91 420 089.4).

To produce TFT circuits, more than one resist pattern must be prepared, and it is usually necessary to prepare from three to five patterns. For all the resist patterns subsequent to the second pattern, the positional relationship is crucial between the new patterns and the TFT pattern which is already laid down on a glass substrate base, and a high degree of precision required in the absolute positional alignment.

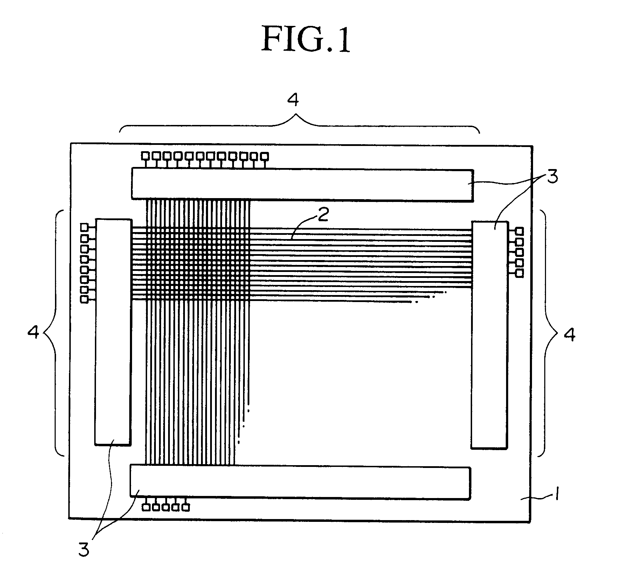

In the previous inventions (USSN 671,037 and the corresponding EPC application 91 420 089.4), the required minimum line width and the positional precision were 2030 μm and about 2-3 μm, respectively. To apply the SS technique, the required minimum width for the TFT circuit and the positional precision must be less than 10 μm and 1-2 μm, respectively. As can be seen in Figure 1, the location of such circuits is around the peripheral regions of the matrix display circuit section. (It should be noted that Figure 1 is a schematic representation of what is actually a far more complex circuitry). in this figure, the numeral 1 represents the glass substrate base, 2 is the matrix circuit section, 3 is the display control circuit section and 4 is the circuitries around the electrode terminal peripheries.

The techniques for printing a circuitry with 10 μm line width and 1-2 μm positional alignment precision are known for a substrate base of c/c dimension of 50 mm. For example, such techniques are disclosed in US Patent No. 4,556,962 and US Patent No. 5,037,504 and JPA First Publication No. H3-150376.

However, there is no technique known for printing patterns, with little defects, having line width less than 10 μm and positional alignment of 1-2 μm, on a glass base of c/c dimension of 40 inches.

This is because it is extremely difficult to achieve positional alignment precision better than 2-3 μm by printing, due to dimensional changes of the printing press introduced by deflections and thermal effects.

Further, even if the printing technique is under control, the thickness variations of the glass base, deflections and thermal dimensional changes and changes at the time of film formation all affect the precision of positional alignment.

For example, even if the alignment of TFT on the glass base pattern is perfect at one side of a resist pattern, it is extremely difficult in practice to maintain the deviation at the other side to less than a few micrometers.

For this reason, it is difficult to manufacture large area matrix type display panels having their peripheral circuitries in the SS configuration. Attempt at manufacturing such panels would result in very poor yield.

An approach based on etching the photoresist patterns to making circuit patterns, shown in figure 2, may be readily suggested from the disclosures in such references as US Patent No.4,556,962, US Patent No. 5,037,504, JPA First Publication No. H2-130738 and JPA First Publication No. H3-30983. However, the productivity by such technique is low, and it would not be a practical technique.

summary of the invention

The objective of the present invention is to present a practical technique of printing the matrix circuit section (referred to as the matrix section) and the peripheral control section on a glass base for use in matrix type large display screens having a c/c dimension of over 20 inches.

The present inventors observed that the line width and the alignment precision of the control section does not vary with the size of the display area, and that driving circuitries, from several to in the teens, can be disposed on the peripheries of the display circuit section, thus leading to the present invention of aligning the circuits for the various sections separately and using printing methods of different precisions.

Specifically, in the manufacture of a large substrate base for use in active matrix type display screes, such as liquid crystal display panels, in which the control circuits are disposed on a common base as the matrix circuits, etching process of the photoresist patterns for the matrix display circuit section, control circuits and electrode terminal peripheral regions are carried out in two or more separate printing steps, depending on the precision and other requirements.

By performing the printing process for circuit patterns for the matrix circuits and electrode terminal peripheral regions on the one hand, separately from the resist patterns for the display control circuits on the other, it becomes possible to utilize a printing press suitable for the particular requirements of the circuitries. Further, by forming the resist patterns for the matrix circuits and for electrode terminal peripheral regions separately from those for the control section, printing conditions suitable for each circuit can be employed; by printing the circuit patterns for the display control section by aligning on the basis of unit of blocks of circuitries, it becomes easy to correct for the deviations in pattern alignment caused by dimensional changes of the large area glass base, and deflections as well as changes due to resist pattern making equipment, thereby allowing to produced large area display panels at high productivity to lower their cost.

Brief Explanation Of The Drawings

Figure 1 is a schematic drawing to illustrate the arrangement of the matrix section and the control section of matrix type display panels.

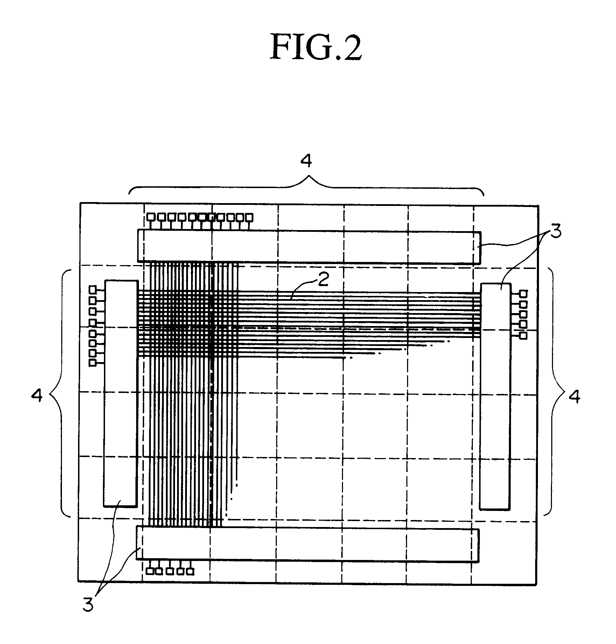

Figure 2 illustrates a conventional resist pattern printing methodology based on units of divided regions of the panel shown in figure 1.

Figure 3 illustrates resist pattern printing based on the methodology of the present invention. The circuits for the matrix and its peripheral regions are printed with a large printing press in one operation while the control circuits are printed by another precision printing machine on the basis of units shown by the squares.

Figure 4 is a cross sectional view of the basic structure of a C-MOS thin film transistor for the control section.

Figure 5 illustrate the etch processing steps for forming the resist patterns.

Figure 6 illustrates the printing steps in the offset-lithography by intaglio plates.

Figure 7 is a schematic illustration to show an application of the method disclosed in USSN 5,037,504 to the present invention.

Preferred Embodiment Of The Invention

A feature of the invented method of printing photoresist patterns for circuitries (referred to as resist patterns), for the matrix circuit section and the display control section on one substrate base, is the use of at least two kinds of printing techniques, depending on requirements, to print the respective resist patterns separately for the matrix display circuit section, display control section and the electrode terminal peripheral circuits (referred to as peripheral circuits).

For the purpose of printing resist patterns for the control section, it is preferred to use printing presses with an alignment capability. Such a press would have a stage on which to place a large glass substrate base. The area per printing should be about c/c dimension of 50 mm. The configuration of the printing press would be different for different printing methods, but an acceptable machine would be one to correspond with the method disclosed in US Patent No. 4,556,962 And US Patent No. 5,037,504 And JPA First Publication No. H3-150376.

The matrix circuits (including relevant display portions such as picture elements section) occupy the relatively large central section of the glass base, and overlaps the display control sections in the peripheral region. The electrode terminal section is located in the peripheral region of the base, and overlaps the control section in the peripheral interconnect section of the control circuits.

Generally speaking, the requirements for the line width and alignment precision for the matrix circuits become less stringent as the substrate base size becomes large. For example, the size of the picture elements becomes large, and the line width can be made broader for a given occupation ratio of the array section. For example, the smallest dimension gate width can be in the range of 20-30 µm, and the alignment precision can also be ±2-3 µm.

In the case of the present invention, the matrix section can be printed in one step, with the use of the printing method disclosed in USSN 671,037 or the corresponding EPC Application 91 420 089.4.

The peripheral circuits are disposed in the peripheral region of the glass base, and the requirements for line width and alignment precision are about the same as or less stringent than those in the matrix section. For forming the resist patterns for the matrix circuits (including the relevant display portions of the picture element sections) and the peripheral circuits, it is usually best to produce all the necessary parts in one printing step. However, depending on the patterns, they can be printed together with those for the control section. Also, screen printing can be carried out for the glass base, and the same time, other patterns can also be printed. Also, if the maximum capacity of the printing machine which can print the matrix circuits is less than the area of the electrode terminal peripheral region, each peripheral region can be printed individually. The choice of the printing method is chosen on the basis of their productivity.

Preferred Embodiment 1

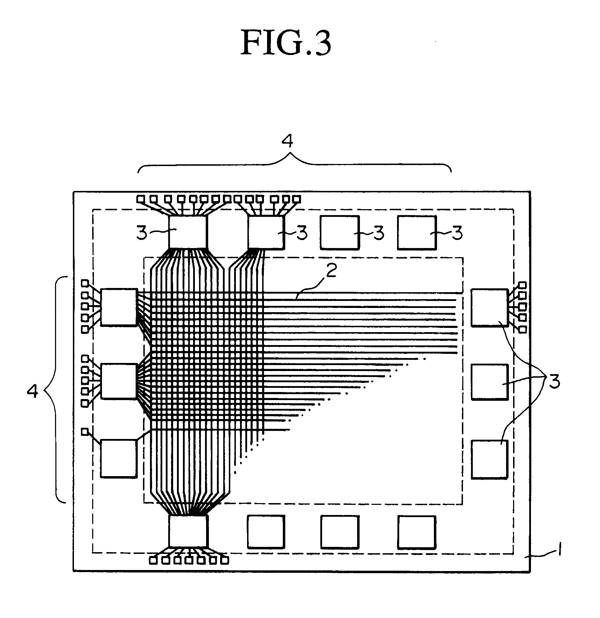

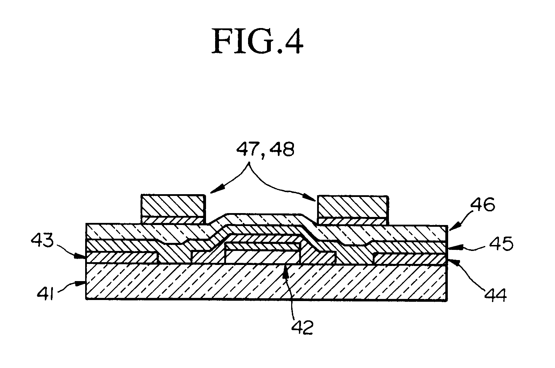

Figure 3 is a simple illustration for explaining one embodiment of the method for making resist patterns, in which the numeral 1 represents a glass substrate base, 2 is a matrix circuit section, 3 is a display control circuit section and 4 is a peripheral circuit region. The drawing scale for the various sections or the number of sections shown in Figure 3 does not represent the actual situations. In actual circuits, the peripheral circuit region 4 and the matrix circuit section 2 to be formed on a glass base 1 of c/c dimension of 40 inches are designed for the minimum line width of 25 µm and alignment precision of ± 4 µm. The display control circuit section 3 is designed for the minimum line width of 6 µm and alignment precision of ± 1.0 µm. The structural elements of the TFT of the display control circuit section 3 are shown in figure 4. The TFT is structured on a glass substrate base 41 covered with a molybdenum thin film 42, followed by a layer of $p^+$ polycrystalline silicon thin film 43, followed by a layer of $n^+$ polycrystalline silicon thin film 44, a layer of laser annealed polysilicon thin film 45, $SiO_2$ thin film 46, $n^+$ polysilicon thin film 47 and aluminum thin film 48. (Reported in extended abstracts of the 1991 International Conference On Solid State Devices And Materials, Yokohama, 1991, pp590-592.)

The peripheral circuit region 4 and matrix circuit section 2 overlaps with the display control circuit section 3 at the connecting section, which is designed to eliminate any electrical contact problems. Also, to contain the relative positions of the peripheral circuit region 4 and the matrix circuit section 2 within allowable design area, alignment marks for locating purposes are disposed at suitable places.

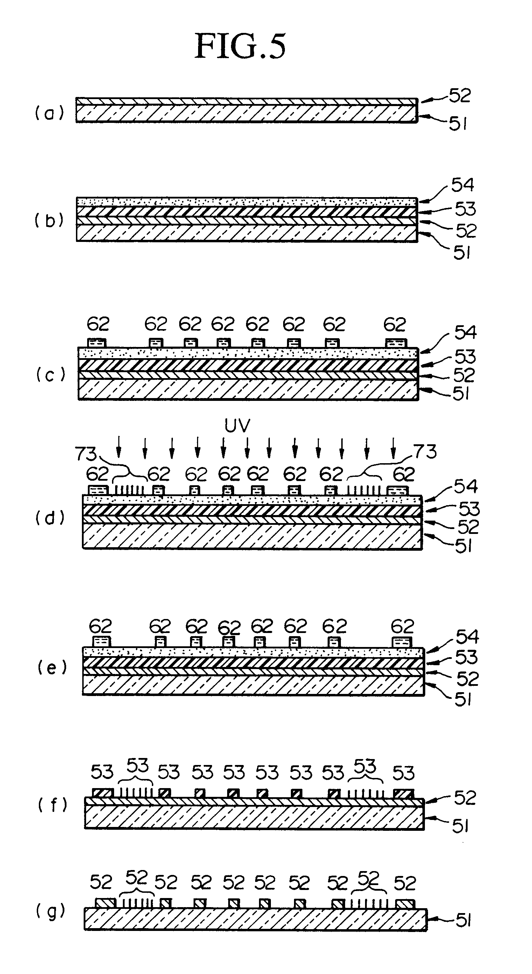

The processing steps to fabricate such components will be explained with reference to Figure 5. Figure 5 (a) shows a step of forming a 0.1 µm thick layer of molybdenum 52 on top of a glass substrate base 1. A 1 µm thick coating of positive type photoresist (OFPR-800 30 CP, which consists primarily of phenol resin and naphthoquinonediazido, made by Tokyo Oka Co.) 53 was applied on top. After a drying step, a 1 µm thick adhesive layer 54 was produced on top of the photoresist layer by applying a coating of an acrylic type liquid adhesive material, as shown in figure 5 (b).

The patterns for the peripheral circuit region 4 and the matrix circuit section, shown in figure 5 (c), were produced by one of the printing methods disclosed in the patent application by the same inventors (USSN 671,037 and the corresponding EPC application 91 420 089.4.), the method of intaglio printing.

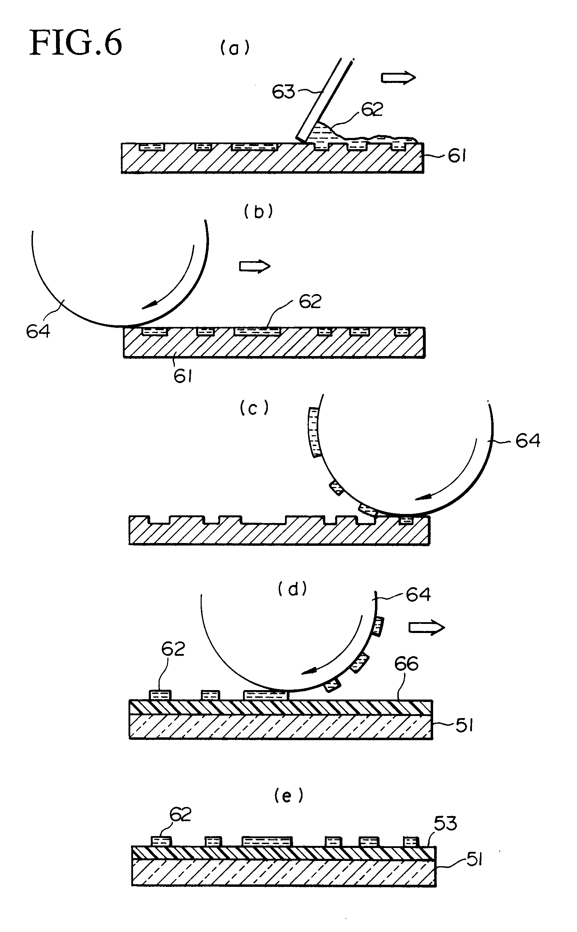

This intaglio method of offset printing will be explained with reference to Figure 6. The printing plate 61 has cavities, to contain the printing ink therein, corresponding to the patterns for the peripheral circuit region 4, which are made by such techniques as etching. After placing ink 62 into the cavities, the excess ink is removed by a doctor blade 63, as illustrated in Figure 6 (a).

Next, the pattern is transferred onto the surface of a blanket roll 64 by rolling the roll 64 over the plate 61 as shown in figures 6 (b) and (c). This is followed by transferring the patterns from the blanket roll 64 to a printing object, i.e. positive type photoresist 53 in this embodiment, to obtain the required ink patterns 66, as illustrated in figures 6 (d) and (e). The ink used in the embodiment was an UV-absorbing (ultraviolet) printing ink containing carbon black in a thermosetting type melamine resin.

Next, the circuit patterns for the display control circuit 3 and the scan control circuit are fabricated, for a unit of three neighboring circuits on the one hand, and those for the data control circuit are fabricated, for a unit of two neighboring circuits on the other, on the above mentioned positive photoresist film as many times as necessary, according to the printing method disclosed in US patent no. 5,037,504. The patterns were aligned by lining up the alignment marks disposed on every unit with respect to the base alignment mark disposed on the matrix circuit 2.

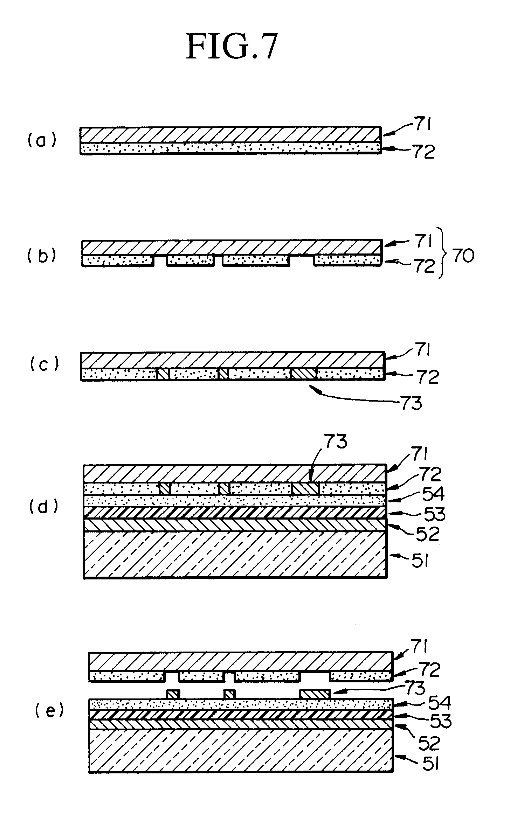

The method of printing according to the above noted US Patent No. 5,037,504 to the first embodiment will be explained with reference to Figure 7. A near mirror-finished stainless strip 71 of 0.2 $\mu$m thickness is spin coated with an aqueous photosensitive solution, consisting primarily of polyvinyl alcohol (PVA) and ammonium dichromate, so as to produce a thickness of about 1.0 $\mu$m after drying (refer to Figure 7 (a). Next, the required fine line patterns (left/right reversed patterns for the molybdenum layer 52) are exposed, and after developing at 30 °c and drying, the film is baked (known as burning) at around 230-260 °c for about 10 minutes to produce a printing plate 70 having water-resistance and electrical insulation properties (Figure 7(b)). Next, the conductive outlines on the exposed printing plate are electroplated with a layer of Ni 73 by arranging the printing plate as the positive electrode and a nickel plate as the negative electrode. The electroplating conditions employed were as follows:

## Electrolyte Composition

| | |
|---|---|
| Nickel sulfate | 240-340 g/l |
| Nickel chloride | 45 g/l |
| Boric acid | 30- 38 g/l |
| pH | 2.5-5.5 |
| Temperature | 46-70 °c |
| Current density | 2.5-10 a/cm$^2$ |

Plating is continued to a thickness of 1 $\mu$m, and the processed printing plates are washed and dried. (refer to Figure 7 (c)).

Next, the adhesive layer 54 on the printing object is tightly pressed against the Ni layer 73 on the printing plate 70 (as in figure 7 (d)) first, then the two parts are separated. As a result, the Ni layer 73 is completely transferred onto the adhesive layer 54 of the printing object, thereby transferring the plated circuit patterns onto the printing object (refer to Figure 7 (e)). This circuit pattern transfer process, in practice, is carried out after the circuit patterns on the peripheral circuit region 4 are lined up with those of the matrix circuit section 2 by means of the alignment marks mentioned above.

Next, as shown in Figure 5 (d), the photoresist surface of the printing plate is exposed to UV radiation from a high pressure mercury lamp. The ink patterns 62 and the Ni plating patterns 73 serve as the UV-radiation shields during this process. After the exposure, the printing plate is immersed in a solution containing hydrochloric acid and nitric acid to remove the acrylic type adhesive layer 54 and the ink 62, and after drying, the exposed photoresist layer is developed in an organic alkaline type developing solution to obtain the resist patterns shown in Figure 5 (f).

For the purpose of forming photoresist patterns, similar steps as described above were carried out on a Si thin film of 0.5 $\mu$m thickness produced by a low pressure chemical vapor deposition (LPCVD) process. Similarly, the required photoresist patterns were produced for $SiO_2$ thin film 46 and for Al thin film 48 layers.

By following the processing steps described above, it was possible to produce photoresist patterns of TFT components, such as molybdenum thin film and Si thin film, on the surface on a large substrate glass base of a c/c dimension of 40 inches, and thereby to produce glass substrate base with a SS configuration for active matrix liquid crystal display panels. Because a large size etching equipment for such large panels are not yet available commercially, etching processes were carried out by quartering the glass substrate base 51 (refer to Figure 5(g)). However, it was possible to confirm that patterning was made with the accuracy required for the display control circuit, matrix display and peripheral circuit regions.

As a result of the circuit printing technology development presented above, it has become possible to actually produce photoresist patterns of SS configuration for use in liquid crystal display panels of a c/c dimension over 40 inches. With this method, even larger display screens with the SS configuration, such as c/c dimension of over 60 inches, can be produced.

In this embodiment, the method based on US patent No. 5,037,504 was employed, but it is clear that those photoresist patterns of c/c dimension of about 50 mm having the minimum line width of 5 $\mu$m disclosed in US patent No. 5,037,504 and JPA First Publication No. H3-30983 can also be produced by the same method when an alignment apparatus of appropriate accuracy is developed.

Second Preferred Embodiment

In this embodiment, the circuit components for display panels of c/c dimension of 40 inches were designed with the following requirements: minimum line width of 30 $\mu$m and alignment accuracy of $\pm$ 5 $\mu$m in the matrix control section; and as in the first preferred embodiment, minimum line width of 6 $\mu$m and alignment accuracy of $\pm$ 1.0 $\mu$m in the peripheral circuit region; and minimum line width of 30 $\mu$m and $\pm$ 5 $\mu$m for a part of the peripheral circuit region, and minimum line width of 100 $\mu$m and $\pm$ 15 $\mu$m in other parts of the peripheral circuit region.

The molybdenum layer and positive type photoresist films (OFPR-800, 30 CP made by Tokyo Oka Co.) were produced in the same way as in the first preferred embodiment.

Next, the matrix circuit section was fabricated by offset printing. The printing plates were plain type TAP plates produced by Toray Company, and the printing ink used was a black ink of the oxidation polymerization type.

After the ink has dried completely, screen printing was employed to print the lines of minimum line width 100 $\mu$m in the peripheral circuit region. The alignment was performed with the alignment marks of 30 $\mu$m line width produced in the offset printing process. The ink used in screen printing was the black ink mentioned above. After the ink has dried completely, the peripheral circuit region was printed according to the method disclosed in US patent NO. 4,556,962. Specifically, negative type photoresist coating (Tokyo Oka OMR-85, which consists primary of cyclization rubber and bisazido) was applied on an Invar strip of 0.3 $\mu$m thickness, and as in the first embodiment, those units of the peripheral control circuits including the peripheral circuits having the minimum line width of 30 $\mu$m were UV-exposed and developed so as to produce printing plates having only the targeted section exposed. This exposed strip was used as the base strip for electroplating.

This base strip was rolled onto a metal roll, such as the one presented in the above-noted US patent NO. 4,556,962, to produce a roll electrode for use in pattern deposition by electroplating. The method used to plate the resin was primarily according to that disclosed in preferred embodiments 7, 10 and 11 in the above-noted US patent No.4,556,962.

The electroplated patterns thus obtained were transferred onto the required location on the TFT substrate base. The alignment marks for the first layer were those made in the offset printing step. The alignment marks used after the second layer printing were those produced by the various printing method presented in the first embodiment. Other processing steps were the same as in the first embodiment.

After the completion of the all the necessary ink patterns, the exposure, development, ink separation and etching steps were carried out as in the first embodiment. By repeating such steps, a glass substrate base containing all the peripheral control circuits for TFT are disposed on a common base was produced.

The reason for applying the initial photoresist coating in this embodiment, was that the printing ink, which is resistant to the etching solution currently being used, contains alkaline impurities. Therefore, contact with the TFT films formed on the substrate base will cause degradation of the circuit performance. If the alkaline impurity concentration in the ink is tolerably low that there is no danger of contamination, there is no need for photoresist coating. Therefore, the photoresist coating is not an essential part of the present invention which is inclusive of those processes not containing photoresist coating steps. In such a case, ink only needs to be resistant to etching process, and there is no need for it to be opaque to UV radiation.

## Claims

1. A method for printing resist patterns for active matrix display type display panels on a large substrate base, wherein a plurality of matrix display circuit sections and plurality of display control circuit sections are fabricated on said substrate base by fabricating means for forming said electrical circuit patterns, wherein said fabricating means involves not less than two different methods of printing means for forming circuit patterns on said substrate base, depending on the resolution accuracies required for the matrix display circuit section, the display control circuit section and electrode terminal peripheral circuit regions.

2. A method for fabricating electrical circuit patterns as claimed in claim 1, wherein said fabricating step, for making photoresist patterns for the display control circuit section, is carried out in units of specific number of display control circuit blocks.

3. A method for fabricating electrical circuit patterns as claimed in claim 1, wherein the resist patterns for the matrix display circuit section and for the electrode terminal circuit section are printed by the method of offset printing.

4. A method for fabricating electrical circuit patterns as claimed in claim 1, wherein the resist patterns for the electrode terminal circuit section are printed by the method of screen printing.

# FIG.1

# FIG.2

# FIG.3

# FIG.4

47, 48
46
43
45
41
44
42

# FIG.5

(a)

(b)

(c)

(d) UV

(e)

(f)

(g)

# FIG.6

(a)

(b)

(c)

(d)

(e)

# FIG.7

(a)

(b)

(c)

(d)

(e)